# EUROPÄISCHE PATENTSCHRIFT

(11) **EP 3 255 797 B1**
(45) Veröffentlichungstag und Bekanntmachung des Hinweises auf die Patenterteilung: **14.11.2018**
(21) Anmeldenummer: 16173926.3
(22) Anmeldetag: 10.06.2016
(51) Int. Cl.: G01R 31/30, G01R 31/28, H03M 1/12, H03M 1/10

(54) **SCHALTUNGSANORDNUNG**
SWITCHING ASSEMBLY
CIRCUIT

(43) Veröffentlichungstag der Anmeldung: 13.12.2017
(73) Patentinhaber: SICK AG, 79183 Waldkirch/Breisgau (DE)
(72) Erfinder: Bogomolni, Igor, 10585 Berlin (DE)
(74) Vertreter: Manitz Finsterwald Patentanwälte PartmbB

(56) Entgegenhaltungen:
- JP-K1- H11 214 996
- US-A1- 2005 093 722
- US-A1- 2005 156 580

## Beschreibung

Die vorliegende Erfindung betrifft eine Schaltungsanordnung gemäß dem Oberbegriff des Anspruchs 1. Die Schaltungsanordnung dient zur Auswertung eines analogen elektrischen Signals und umfasst eine Steuereinrichtung, eine Eingangsschaltung zum Anlegen eines Eingangssignals, eine mit der Eingangsschaltung elektrisch verbundenen Konditionierungsschaltung zur Umwandlung des Eingangssignals in ein Messsignal und einen mit der Konditionierungsschaltung elektrisch verbundenen Analog-Digital-Umsetzer zur Umwandlung des Messsignals in einen digitalen Wert und einer Referenzquelle, die ein bekanntes Referenzsignal ausgibt.

Derartige Schaltungsanordnungen dienen beispielsweise dazu, analoge elektrische Signale (d.h. Eingangssignale) in digitale Werte umzuwandeln, wobei die digitalen Werte z.B. von der Steuereinrichtung weiterverarbeitet werden können.

Insbesondere bei Verwendung der Schaltungsanordnung in Sicherheitsgeräten, d.h. beispielsweise in Geräten, die das "Safety Integrity Level 3 (SIL3)" erfüllen, muss sichergestellt werden, dass die Schaltungsanordnung korrekt funktioniert. Beispielsweise muss die Schaltungsanordnung hier in der Lage sein, Fehler in der Schaltungsanordnung selbst, wie z.B. Leitungskurzschlüsse oder Manipulationen bzw. Veränderungen an Bauteilen, zu erkennen.

Aus der US 2005/0093722 A1 ist eine Schaltungsanordnung gemäß dem Oberbegriff des Anspruchs 1 bekannt. Die JP H11 214996 K1 offenbart eine Schaltungsanordnung zur Bestimmung eines Offset- und eines Verstärkungsfehlers.

Es ist die der Erfindung zugrundeliegende Aufgabe, eine universell einsetzbare Schaltungsanordnung zur Verwendung in sicheren Geräten anzugeben, die ausgebildet ist, Fehler der Schaltungsanordnung zuverlässig und auf einfache Weise zu erkennen.

Diese Aufgabe wird mit der Schaltungsanordnung gemäß Anspruch 1 und insbesondere durch die Merkmale des kennzeichnenden Teils gelöst.

Gemäß Anspruch 1 ist eine erste Schaltvorrichtung vorgesehen, die das Eingangssignal wahlweise von der Konditionierungsschaltung trennt oder der Konditionierungsschaltung zuführt, und ist eine zweite Schaltvorrichtung vorgesehen, die das Referenzsignal wahlweise der Eingangsschaltung zuführt oder von der Eingangsschaltung trennt. Hierbei ist die Steuereinrichtung ausgebildet, einen Offsetfehler der Schaltungsanordnung zu bestimmen, wenn das Eingangssignal von der Konditionierungsschaltung getrennt ist und das Referenzsignal nicht der Eingangsschaltung zugeführt wird, und/oder einen Verstärkungsfehler der Schaltungsanordnung zu bestimmen, wenn das Eingangssignal von der Konditionierungsschaltung getrennt ist und das Referenzsignal der Eingangsschaltung zugeführt wird.

Der Erfindung liegt die Erkenntnis zugrunde, dass durch das Vorsehen der Schaltvorrichtungen verschiedene bekannte Signale durch die Schaltungsanordnung ausgewertet (d.h. gemessen) werden können, wobei aus einem Vergleich des (tatsächlich gemessenen) digitalen Werts und eines erwarteten digitalen Werts der Offsetfehler und/oder der Verstärkungsfehler der Schaltungsanordnung bestimmt werden können. Aus dem Offsetfehler und dem Verstärkungsfehler kann wiederum auf Fehler in der Schaltungsanordnung rückgeschlossen werden, wodurch insbesondere erhöhte Sicherheitsanforderungen erfüllt werden können.

Durch die Erfassung des Offsetfehlers und/oder des Verstärkungsfehlers kann zudem eine Kalibrierung der Schaltungsanordnung erfolgen. Erfindungsgemäß wird es somit ermöglicht, die Schaltungsanordnung zu kalibrieren und gleichzeitig Fehler, wie Offset- und Verstärkungsfehler, eine Temperaturdrift oder Bauteildefekte, zu ermitteln. Auf diese Weise kann eine hohe Präzision der Schaltungsanordnung auch mit kostengünstigen Bauteilen erzielt werden.

Der digitale Wert, der von dem Analog-Digital-Umsetzer aus dem Messsignal erzeugt wird, wird im Folgenden auch als der gemessene digitale Wert bezeichnet.

Der Offsetfehler und/oder der Verstärkungsfehler können systematische Fehler in der Schaltungsanordnung sein. Bei dem Offsetfehler kann es sich um einen Fehler handeln, der einen zu hohen oder zu niedrigen digitalen Wert verursacht, wobei der Offsetfehler zumindest im Wesentlichen unabhängig von der Größe des Eingangssignals ist. Der Verstärkungsfehler kann ein Fehler sein, der einen zu hohen oder zu niedrigen digitalen Wert verursacht, wobei der Verstärkungsfehler von der Größe des Eingangssignals bzw. des an der Konditionierungsschaltung anliegenden Signals abhängt. Zum Beispiel nimmt der Verstärkungsfehler linear mit dem Eingangssignal zu.

Für den Fall, dass die erste Schaltvorrichtung das Eingangssignal von der Konditionierungsschaltung trennt und die zweite Schaltvorrichtung das Referenzsignal nicht der Eingangsschaltung zuführt, ist das an der Konditionierungsschaltung anliegende Signal "Null", d.h. beispielsweise auf einem Massepotential liegen. Bei einer derartigen Schaltung der Schaltvorrichtungen müsste der Analog-Digital-Umsetzer also einen digitalen Wert ausgeben, der einem Eingangssignal von Null entspricht. Weicht der digitale Wert von dem in diesem Fall erwarteten digitalen Wert ab, so kann aus der Abweichung auf den Offsetfehler geschlossen werden. Insbesondere entspricht die Abweichung dem Offsetfehler.

Bei der Ermittlung des Offsetfehlers wird ausgenutzt, dass selbst bei Vorhandensein eines Verstärkungsfehlers, der Verstärkungsfehler nur geringe Auswirkungen auf den digitalen Wert hat, da ein Signal von im Wesentlichen Null verstärkt wird und der Verstärkungsfehler damit nur geringe Auswirkungen haben kann.

Zur Bestimmung des Verstärkungsfehlers trennt die erste Schaltvorrichtung das Eingangssignal von der Konditionierungsschaltung und wird das Referenzsignal der Eingangsschaltung mittels der zweiten Schaltvorrichtung zugeführt. Hierdurch liegt an der Eingangsschaltung (und an einem Eingang der Konditionierungsschaltung) ein definiertes Signal an, nämlich das Referenzsignal. Wird das Referenzsignal in der Konditionierungsschaltung mit einem ungewünschten Faktor verstärkt, so kann dies wiederum festgestellt werden, da der erwartete digitale Wert für das Referenzsignal als Eingangssignal bekannt ist. Aus einer Abweichung von dem erwarteten digitalen Wert und dem in diesem Zustand gemessenen digitalen Wert kann dann auf den Verstärkungsfehler geschlossen werden. Der Verstärkungsfehler kann beispielsweise durch die Berechnung des Verhältnisses zwischen gemessenem digitalen Wert und erwartetem digitalen Wert ermittelt werden.

Beispielsweise wird bei der Ermittlung des Verstärkungsfehlers davon ausgegangen, dass der Offsetfehler Null ist. Alternativ kann von dem während der Bestimmung des Verstärkungsfehlers ermittelten digitalen Wert auch zunächst der Offsetfehler subtrahiert und anschließend der Verstärkungsfehler bestimmt werden.

Bevorzugt werden nach der Bestimmung von Offsetfehler und Verstärkungsfehler die bei der Bestimmung von Offsetfehler und Verstärkungsfehler gemessenen digitalen Werte auf ihre Plausibilität überprüft. Hierdurch können Fehler in der Schaltungsanordnung aufgedeckt werden, wobei z.B. besonders hohe Offset- und/oder Verstärkungsfehler auf Fehler in der Schaltungsanordnung hinweisen können.

Bei dem Eingangssignal kann es sich beispielsweise um ein analoges Signal eines Temperatur- oder Drucksensors handeln. Die Eingangsschaltung dient dazu, das Eingangssignal an die Konditionierungsschaltung weiterzuleiten. Die Konditionierungsschaltung wandelt das Eingangssignal in das Messsignal um. Hierbei dient die Konditionierungsschaltung insbesondere dazu, das Eingangssignal so zu verändern, dass das Eingangssignal mit dem Analog-Digital-Umsetzer möglichst präzise in einen digitalen Wert gewandelt werden kann. Nach der Veränderung des Eingangssignals durch die Konditionierungsschaltung wird das Eingangssignal als Messsignal bezeichnet. Das Messsignal wird schließlich dem Analog-Digital-Umsetzer zugeführt, welcher das Messsignal in den digitalen Wert umwandelt. Eine Veränderung des Eingangssignals muss dabei nicht bedeuten, dass die Größe (z.B. die Spannung) des Eingangssignals verändert wird. Die Veränderung des kann z.B. auch durch einen Impedanzwandler erfolgen, der es ermöglicht, das Messsignal mit einem höheren Strom auszugeben als dies bei dem Eingangssignal möglich wäre.

Die Referenzquelle kann beispielsweise einen bekannten Spannungswert oder einen bekannten Stromwert ausgeben, der als Referenzsignal dient. Alternativ kann es sich bei dem Referenzsignal auch z.B. um ein gepulstes Signal oder um ein Signal veränderlicher Größe handeln.

Weitere vorteilhafte Weiterbildungen der Erfindung sind der Beschreibung, den Figuren sowie den Unteransprüchen zu entnehmen.

Gemäß einer vorteilhaften Ausführungsform ist die Steuereinrichtung mit dem Analog-Digital-Umsetzer verbunden und korrigiert den Verstärkungsfehler und/oder den Offsetfehler in dem digitalen Wert. Die Steuereinrichtung kann den digitalen Wert in einen digitalen Ausgabewert umsetzen, der um den Verstärkungsfehler und/oder den Offsetfehler bereinigt ist. Hierzu kann von dem digitalen Wert zunächst der Offsetfehler abgezogen und das Ergebnis dieser Subtraktion anschließend mit einem Faktor multipliziert werden, welcher den Verstärkungsfehler ausgleicht.

Gemäß einer weiteren vorteilhaften Ausführungsform ist die Steuereinrichtung ausgebildet, den Offsetfehler und/oder den Verstärkungsfehler wiederholt zu bestimmen, bevorzugt während eines regulären Betriebs der Schaltungsanordnung. Durch eine zyklische Bestimmung des Offsetfehlers und/oder des Verstärkungsfehlers können beispielsweise Temperaturänderungen aber auch Bauteilalterungen und dergleichen im Betrieb der Schaltungsanordnung erkannt und ausgeglichen werden.

Besonders bevorzugt ist die Steuereinrichtung ausgebildet, den Offsetfehler und den Verstärkungsfehler nacheinander zu bestimmen und zwischen der Bestimmung des Offsetfehlers und des Verstärkungsfehlers das Eingangssignal auszuwerten. Dies bedeutet, dass die Schaltungsanordnung die Messung bzw. Auswertung des Eingangssignals jeweils nur für kurze Zeit unterbrechen muss, um einen der Fehler zu bestimmen. Anschließend wird wieder eine "normale" Messung und Auswertung des Eingangssignals (d.h. des von der Schaltungsanordnung zu erfassenden Signals) vorgenommen. Erst danach wird der andere der Fehler bestimmt. Die insofern lediglich kurzen Unterbrechungen des eigentlichen Messvorgangs der Schaltungsanordnung können somit unmerklich für einen Benutzer der Schaltungsanordnung sein.

Erfindungsgemäß ist die Steuereinrichtung ausgebildet, anhand des Offsetfehlers und/oder des Verstärkungsfehlers Bauteilfehler der Schaltungsanordnung zu erkennen und bei Erkennen eines Bauteilfehlers ein Warnsignal auszugeben. Insbesondere bei sicherheitskritischen Anwendungen ab dem Safety Integrity Level 3 müssen Bauteilfehler, Kurzschlüsse, Unterbrechungen und fehlerhafte Wertänderungen von Bauteilen erkannt werden
können. Beispielsweise kann es hier notwendig sein, die Verdopplung des Widerstandswerts eines Bauteils oder dessen Halbierung zu erkennen.

Gemäß einer weiteren vorteilhaften Ausführungsform umfasst die Eingangsschaltung zwei Anschlussklemmen für das Eingangssignal und eine Schutzschaltung, wobei eine der Anschlussklemmen vorzugsweise mit einem Massepotential verbunden ist. An die Anschlussklemmen kann das Eingangssignal angelegt werden, wobei durch die Schutzschaltung beispielsweise Spannungsspitzen des Eingangssignals, die zu Schäden an der Schaltungsanordnung führen könnten, herausgefiltert werden können. Die Schutzschaltung kann hierzu zwischen die Anschlussklemmen geschaltet sein und z.B. eine Zener-Diode umfassen. Außerdem kann die Eingangsschaltung auch die erste Schaltvorrichtung umfassen.

Gemäß einer weiteren vorteilhaften Ausführungsform umfasst die Konditionierungsschaltung einen Spannungsteiler. Der Spannungsteiler kann so verschaltet sein, dass er zwischen die zwei Anschlussklemmen schaltbar ist und eine Spannung des Eingangssignals beispielsweise mit einem Teilverhältnis von 1:10 teilt. Der Spannungsteiler kann von einer der Anschlussklemmen mittels der ersten Schaltvorrichtung trennbar sein.

Der Spannungsteiler kann insbesondere zwei in Reihe geschaltete Widerstände umfassen, wobei ein Ausgang des Spannungsteilers zwischen seinen beiden Widerständen vorgesehen ist. Der Spannungsteiler kann dazu dienen, Eingangssignale mit hohen Spannungen zu messen, ohne dass der Analog-Digital-Umsetzer einen genauso hohen Eingangsspannungsbereich aufweisen muss.

Gemäß einer weiteren vorteilhaften Ausführungsform umfasst die Konditionierungsschaltung einen Impedanzwandler, insbesondere einen Spannungsfolger. Der Impedanzwandler kann bevorzugt einen ersten Operationsverstärker umfassen. Ein nicht-invertierender Eingang des ersten Operationsverstärkers kann mit dem Ausgang des Spannungsteilers gekoppelt sein. Ein invertierender Eingang des ersten Operationsverstärkers kann mit dem Ausgang des ersten Operationsverstärkers elektrisch verbunden sein.

Der Impedanzwandler kann dazu dienen, einen durch die Anschlussklemmen fließenden Strom des Eingangssignals zu minimieren und auf diese Weise Veränderungen des Eingangssignals durch die Messung zu reduzieren.

Gemäß einer weiteren vorteilhaften Ausführungsform umfasst die Konditionierungsschaltung einen Verstärker, insbesondere einen invertierenden Verstärker. Der Verstärker kann einen zweiten Operationsverstärker umfassen, wobei ein nicht-invertierender Eingang des zweiten Operationsverstärkers mit dem Ausgang des Spannungsfolgers gekoppelt sein kann. Ein invertierender Eingang des zweiten Operationsverstärkers kann über einen ersten Widerstand mit dem Massepotential und gleichzeitig über einen zweiten Widerstand mit einem Ausgang des zweiten Operationsverstärkers verbunden sein. Über das Verhältnis der Größen des ersten und des zweiten Widerstands kann eine Verstärkung des Verstärkers eingestellt werden. Aufgrund der wählbaren Verstärkung kann die Schaltungsanordnung an das Eingangssignal angepasst werden.

Erfindungsgemäß addiert die Konditionierungsschaltung das Referenzsignal dem Messsignal hinzu. Durch die Addition des Referenzsignals zu dem Messsignal wird dem Messsignal ein Offset hinzugefügt, welcher es gestattet, z.B. auch negative Eingangssignale mit dem Analog-Digital-Umsetzer auszuwerten, auch wenn der Analog-Digital-Umsetzer z.B. nur zur Verarbeitung positiver Signale in der Lage ist. Dabei kann das Referenzsignal so groß gewählt sein, dass es der Hälfte des maximal von dem Analog-Digital-Umsetzer verarbeitbaren Signalpegels entspricht. Auf diese Weise können gleich große negative und positive Eingangssignale von der Schaltungsanordnung verarbeitet werden.

Besonders bevorzugt umfasst die Referenzquelle eine Spannungsquelle. Dies bedeutet, dass die Referenzquelle eine vorbestimmte und vorzugsweise unveränderliche Spannung ausgibt. Die vorbestimmte Spannung der Referenzquelle kann temperaturstabilisiert sein.

Alternativ oder zusätzlich kann die Referenzquelle auch eine Stromquelle umfassen. Die Stromquelle gibt einen vorbestimmten und vorzugsweise unveränderlichen Strom aus. Auch der vorbestimmte Strom kann temperaturstabilisiert sein.

Auch bei der Verwendung der Schaltungsanordnung zur Strommessung kann es sich bei der Referenzquelle um eine Spannungsquelle handeln.

Die Referenzquelle kann zusätzlich direkt mit dem Analog-Digital-Umsetzer verbunden sein, um eventuelle Fehler des Analog-Digital-Umsetzers oder der Referenzquelle zu erkennen. Hierzu kann das Referenzsignal von dem Analog-Digital-Umsetzer in einen digitalen Wert umgewandelt werden, wobei ein hierbei erwarteter digitaler Wert mit dem tatsächlich gemessenen digitalen Wert verglichen wird, um Fehler des Analog-Digital-Umsetzers und/oder der Referenzquelle zu erkennen.

Gemäß einer weiteren vorteilhaften Ausführungsform umfasst die Eingangsschaltung einen Shunt-Widerstand. Der Shunt-Widerstand kann zur indirekten Strommessung dienen, sofern mit der Schaltungsanordnung Ströme gemessen werden sollen. Der Shunt-Widerstand kann zwischen die Anschlussklemmen der Eingangsschaltung geschaltet sein. Fließt nun durch den Shunt-Widerstand ein Strom, kann die am Shunt-Widerstand abfallende Spannung als Eingangssignal verwendet werden.

Dient die Schaltungsanordnung zur Messung von Spannungen, kann die Referenzquelle eine Spannungsquelle sein. Dient die Schaltungsanordnung hingegen zur Erfassung von Strömen, so kann die Referenzquelle als Stromquelle ausgebildet sein. Außerdem kann auch sowohl eine Spannungsquelle als auch eine Stromquelle von der Referenzquelle umfasst sein, so dass zwischen der Spannungs- und der Stromquelle umgeschaltet werden kann.

Bevorzugt kann die Größe des Referenzsignals veränderbar und/oder einstellbar sein. Hierdurch kann die Schaltungsanordnung an verschiedenen Arbeitspunkten getestet werden. Zur Einstellung des Referenzsignals kann die Referenzquelle selbst veränderbar sein und/oder es können verschiedene Referenzquellen vorgesehen sein, die wahlweise verwendet werden.

Gemäß einer weiteren vorteilhaften Ausführungsform umfasst die Schaltungsanordnung eine zweite Eingangsschaltung zum Anlegen eines zweiten Eingangssignals, eine mit der zweiten Eingangsschaltung elektrisch verbundene zweite Konditionierungsschaltung zur Veränderung des Eingangssignals in ein zweites Messsignal, einen mit der zweiten Konditionierungsschaltung elektrisch verbundenen zweiten Analog-Digital-Umsetzer zur Umwandlung des zweiten Messsignals in einen zweiten digitalen Wert und eine zweite Referenzquelle, die ein bekanntes zweites Referenzsignal ausgibt. Dabei ist bevorzugt eine weitere erste Schaltvorrichtung vorgesehen, die das Eingangssignal wahlweise von der zweiten Konditionierungsschaltung trennt oder der zweiten Konditionierungsschaltung zuführt, und es ist eine weitere zweite Schaltvorrichtung vorgesehen, die das Referenzsignal wahlweise der zweiten Eingangsschaltung zuführt oder von der zweiten Eingangsschaltung trennt. Die Steuereinrichtung ist bevorzugt ausgebildet, einen zweiten Offsetfehler der Schaltungsanordnung zu bestimmen, wenn das zweite Eingangssignal von der zweiten Konditionierungsschaltung getrennt ist und das zweite Referenzsignal nicht der zweiten Eingangsschaltung zugeführt wird, und/oder einen zweiten Verstärkungsfehler der Schaltungsanordnung zu bestimmen, wenn das zweite Eingangssignal von der zweiten Konditionierungsschaltung getrennt ist und das zweite Referenzsignal der zweiten Eingangsschaltung zugeführt wird.

Zum Beispiel werden der zweite Offsetfehler und/oder der zweite Verstärkungsfehler von der zweiten Eingangsschaltung und/oder der zweiten Konditionierungsschaltung verursacht.

Generell kann die Schaltungsanordnung also redundant aufgebaut sein, wobei jeweils mehrere parallel angeordnete Eingangs- und/oder Konditionierungsschaltungen und/oder Analog-Digital-Umsetzer vorhanden sind. Die Eingangsschaltungen, die Konditionierungsschaltungen und/oder die Analog-Digital-Umsetzer können jeweils identisch aufgebaut sein. Die obigen Ausführungen zu möglichen Weiterbildungen der Schaltungsanordnung gelten entsprechend für die redundanten Teile der Schaltungsanordnung, also beispielsweise für die zweite Eingangsschaltung, die zweite Konditionierungsschaltung, den zweiten Analog-Digital-Umsetzer und die weiteren Schaltvorrichtungen.

Gemäß einer weiteren vorteilhaften Ausführungsform ist die Steuereinrichtung ausgebildet, den zweiten Offsetfehler und/oder den zweiten Verstärkungsfehler zu anderen Zeitpunkten zu bestimmen, als den Offsetfehler und/oder den Verstärkungsfehler. Bei einer redundant ausgelegten Schaltungsanordnung kann auf diese Weise jeweils ein Teil der Schaltungsanordnung für "reguläre" Messungen des Eingangssignals zur Verfügung stehen. Trotzdem kann im normalen Betrieb die Erfassung der Offsetfehler und/oder der Verstärkungsfehler erfolgen.

Das erste und das zweite Eingangssignal können gleich oder verschieden sein. Beispielsweise kann ein mit der Schaltungsanordnung gekoppelter Sensor redundant vorhanden sein, so dass den Eingangsschaltungen Eingangssignale von unterschiedlichen Sensoren zugeleitet werden. Aufgrund dieser Redundanz können besonders hohe Sicherheitsanforderungen erfüllt werden.

Weiterer Gegenstand der Erfindung ist ein Verfahren zur Auswertung eines analogen elektrischen Signals, bei welchem ein Eingangssignal an eine Eingangsschaltung angelegt wird, eine mit der Eingangsschaltung elektrisch verbundene Konditionierungsschaltung das Eingangssignal in ein Messsignal umwandelt, ein mit der Konditionierungsschaltung elektrisch verbundener Analog-Digital-Umsetzer das Messsignal in einen digitalen Wert umwandelt und eine Referenzquelle ein bekanntes Referenzsignal ausgibt. Dabei wird mittels einer ersten Schaltvorrichtung das Eingangssignal wahlweise von der Konditionierungsschaltung getrennt oder der Konditionierungsschaltung zugeführt und mittels einer zweiten Schaltvorrichtung das Referenzsignal wahlweise der Eingangsschaltung zugeführt oder von der Eingangsschaltung getrennt, wobei ein Offsetfehler bestimmt wird, wenn das Eingangssignal von der Konditionierungsschaltung getrennt ist und das Referenzsignal nicht der Eingangsschaltung zugeführt wird, und/oder ein Verstärkungsfehler bestimmt wird, wenn das Eingangssignal von der Konditionierungsschaltung getrennt ist und das Referenzsignal der Eingangsschaltung zugeführt wird.

Zu dem erfindungsgemäßen Verfahren gelten die zu der erfindungsgemäßen Schaltungsanordnung getroffenen Aussagen entsprechend, insbesondere hinsichtlich Vorteilen und bevorzugter Ausführungsformen.

Nachfolgend wird die Erfindung rein beispielhaft unter Bezugnahme auf die Zeichnungen beschrieben. Es zeigen:
- Fig. 1: eine erste Ausführungsform einer Schaltungsanordnung, welche zur Spannungsmessung dient; und
- Fig. 2: eine zweite Ausführungsform einer Schaltungsanordnung, welche zur Strommessung dient.

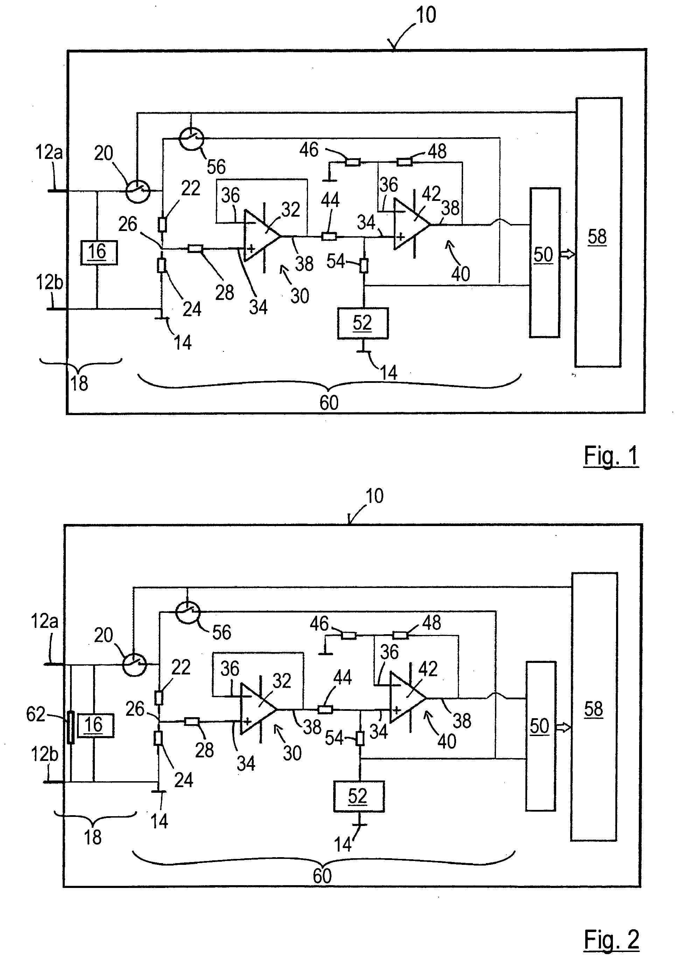

Fig. 1 zeigt eine erste Ausführungsform einer Schaltungsanordnung 10, die zur Auswertung eines analogen elektrischen Signals (d.h. eines elektrischen Eingangssignals) dient. Die Schaltungsanordnung 10 umfasst eine erste Anschlussklemme 12a und eine zweite Anschlussklemme 12b, an welche das elektrische Eingangssignal angelegt werden kann. Die zweite Anschlussklemme 12b ist mit dem Massepotential 14 elektrisch verbunden.

Zwischen den zwei Anschlussklemmen 12 ist eine EMV-Schutzschaltung 16 angeordnet, die mit den Anschlussklemmen 12 elektrisch verbunden ist. Die EMV-Schutzschaltung 16 dient dazu, beispielsweise Überspannungen abzuleiten.

Ein erster Schalter 20 ist mit der ersten Anschlussklemme 12a verbunden und gestattet es, die Anschlussklemme 12a wahlweise mit einem ersten Widerstand 22 zu verbinden oder die Anschlussklemme 12a von dem ersten Widerstand 22 zu trennen. Die Anschlussklemmen 12 sowie die EMV-Schutzschaltung 16 und der erste Schalter 20 bilden gemeinsam eine Eingangsschaltung 18.

Der erste Schalter 20 ist mittels eines ersten Widerstands 22 mit einem zweiten Widerstand 24 verbunden, wobei der zweite Widerstand 24 auch mit dem Massepotential 14 gekoppelt ist. Der erste und der zweite Widerstand 22, 24 sind in Reihe geschaltet und bilden gemeinsam einen Spannungsteiler, dessen Ausgang 26 über einen dritten Widerstand 28 mit einem Spannungsfolger 30 verbunden ist. Der Ausgang 26 liegt zwischen dem ersten und dem zweiten Widerstand 22, 24.

Der Spannungsfolger 30 umfasst einen ersten Operationsverstärker 32, dessen nicht-invertierender Eingang 34 über den dritten Widerstand 28 mit dem Ausgang 26 des Spannungsteilers verbunden ist. Ein invertierender Eingang 36 des ersten Operationsverstärkers 32 ist mit einem Ausgang 38 des ersten Operationsverstärkers 32 gekoppelt.

Dem Spannungsfolger 30 nachgeschaltet ist ein invertierender Verstärker 40. Der invertierende Verstärker 40 umfasst einen zweiten Operationsverstärker 42, dessen nicht-invertierender Eingang 34 über einen vierten Widerstand 44 mit dem Ausgang 38 des ersten Operationsverstärkers 32 verbunden ist. Der invertierende Eingang 36 des zweiten Operationsverstärkers 42 ist über einen fünften Widerstand 46 mit dem Massepotential 14 gekoppelt. Zugleich ist der invertierende Eingang 36 des zweiten Operationsverstärkers 42 über einen sechsten Widerstand 48 mit dem Ausgang 38 des zweiten Operationsverstärkers 42 verbunden. Der Ausgang 38 des zweiten Operationsverstärkers 42 ist zugleich auch mit einem Analog-Digital-Umsetzer 50 verbunden. An dem Ausgang 38 des zweiten Operationsverstärkers 42 liegt im Betrieb der Schaltungsanordnung 10 ein Messsignal an, das von dem Analog-Digital-Umsetzer 50 in einen digitalen Wert umgewandelt wird.

In der Schaltungsanordnung 10 ist eine Spannungsquelle als Referenzquelle 52 vorgesehen, die ein Referenzsignal über einen siebten Widerstand 54 dem nichtinvertierenden Eingang 34 des zweiten Operationsverstärkers 42 zuführt. Das Referenzsignal und damit auch die Referenzquelle 52 kann mittels eines zweiten Schalters 56 wahlweise mit dem ersten Widerstand 22 und dem ersten Schalter 20 verbunden oder von dem ersten Widerstand 22 und dem ersten Schalter 20 getrennt werden. Zudem ist die Referenzquelle 52 mit dem Analog-Digital-Umsetzer 50 gekoppelt und liefert das Referenzsignal an den Analog-Digital-Umsetzer 50.

Der Analog-Digital-Umsetzer 50 liefert Ausgangswerte an eine Steuereinheit in Form eines Mikrocontrollers 58. Der Mikrocontroller 58 ist mit dem ersten Schalter 20 und dem zweiten Schalter 56 verbunden. Der Mikrokontroller 58 ist in der Lage, die Schalter 20, 56 zu betätigen.

Die genannten Widerstände 22, 24, 28, 44, 46, 48, 54 zusammen mit der Referenzquelle 52 und den Operationsverstärkern 32, 42 des Spannungsfolgers 30 und des invertierenden Verstärkers 40 bilden eine Konditionierungsschaltung 60.

Soll im Betrieb der Schaltungsanordnung 10 ein Spannungssignal (d.h. das Eingangssignal) an den Anschlussklemmen 12 gemessen werden, so wird der erste Schalter 20 geschlossen und der zweite Schalter 56 geöffnet. Das Eingangssignal wird somit dem aus dem ersten Widerstand 22 und dem zweiten Widerstand 24 gebildeten Spannungsteiler zugeleitet. Der Spannungsteiler kann beispielsweise eine Teilung im Verhältnis 1:10 vornehmen (d.h. der erste Widerstand 22 ist neunmal so groß, wie der zweite Widerstand 24). Ein Signal in der Größe von 10% des Eingangssignals wird dann dem Spannungsfolger 30 zugeleitet und an dessen Ausgang 38 übertragen.

Über den siebten Widerstand 54 wird diesem Signal das Referenzsignal der Referenzquelle 52 hinzuaddiert und das Ergebnis dieser Addition dem invertierenden Verstärker 40 zugeführt. Der invertierende Verstärker 40 kann insbesondere einen Verstärkungsfaktor von minus eins aufweisen. Das somit invertierte Signal wird dann als Messsignal an den Analog-Digital-Umsetzer 50 ausgegeben und von dem Analog-Digital-Umsetzer 50 in einen digitalen Wert gewandelt.

Soll nun ein Offsetfehler der Schaltungsanordnung 10 ermittelt werden, so werden der erste Schalter 20 und der zweite Schalter 56 geöffnet. Bei den Schaltern 20, 56 kann es sich z.B. um Solid State Relais handeln. Im Idealfall liegt folglich ein Signal von 0 Volt an dem Spannungsteiler an, da dieser lediglich mit dem Massepotential 14 gekoppelt ist. Nach dem Spannungsfolger 30 sollte demnach immer noch ein Signal von 0 Volt vorliegen, zu dem das Referenzsignal hinzuaddiert wird. Nach der Invertierung des Referenzsignals kann ein von dem Analog-Digital-Umsetzer 50 erzeugter digitaler Wert mit einem erwarteten Wert verglichen werden, der bei Wandlung ausschließlich des Referenzsignals entstanden wäre. Liegt eine Differenz zwischen dem erwarteten digitalen Wert und dem tatsächlich gemessenen digitalen Wert vor, so entspricht diese Differenz dem Offset der Schaltungsanordnung 10.

Zur Ermittlung eines Verstärkungsfehlers wird der erste Schalter 20 geöffnet und der zweite Schalter 56 geschlossen. Hierdurch wird das Referenzsignal der Eingangsschaltung 18 (genauer gesagt dem ersten Schalter 20) und zugleich dem Spannungsteiler, welcher aus dem ersten Widerstand 22 und dem zweiten Widerstand 24 gebildet ist, zugeführt. Das Referenzsignal wird von dem Spannungsteiler verringert und über den Spannungsfolger 30 dem invertierenden Verstärker 40 zugeführt, wobei zwischen dem Spannungsfolger 30 und dem invertierenden Verstärker 40 das Referenzsignal zu dem reduzierten Referenzsignal hinzuaddiert wird. Das hierbei entstehende Signal wird wiederum invertiert und dem Analog-Digital-Umsetzer 50 zugeführt. Aus einem Unterschied zwischen einem erwarteten digitalen Wert des Analog-Digital-Umsetzers 50 und dem tatsächlichen digitalen Wert kann ein Faktor bestimmt werden, der dem Verstärkungsfehler der Schaltungsanordnung 10 entspricht.

Von dem Mikrocontroller 58 können der Offsetfehler und der Verstärkungsfehler zyklisch wiederholt im Betrieb der Schaltungsanordnung 10 bestimmt werden. Die jeweils aktuellen Offset- und Verstärkungsfehler können dazu verwendet werden, die ausgegebenen digitalen Werte (d.h. die Messergebnisse) zu korrigieren und damit die Genauigkeit der Schaltungsanordnung zu erhöhen.

Die in Fig. 2 gezeigte zweite Ausführungsform der Schaltungsanordnung 10 unterscheidet sich von der ersten Ausführungsform der Schaltungsanordnung 10 von Fig. 1 lediglich dadurch, dass die zweite Ausführungsform zwischen den Anschlussklemmen 12a, 12b einen Shunt-Widerstand 62 besitzt, der die Schaltungsanordnung 10 dazu befähigt, indirekt Ströme zu messen.

### Bezugszeichenliste

- 10: Schaltungsanordnung
- 12a, 12b: Anschlussklemmen
- 14: Massepotential
- 16: EMV-Schutzschaltung
- 18: Eingangsschaltung
- 20: erster Schalter
- 22: erster Widerstand
- 24: zweiter Widerstand
- 26: Ausgang des Spannungsteilers
- 28: dritter Widerstand
- 30: Spannungsfolger
- 32: erster Operationsverstärker
- 34: nicht-invertierender Eingang
- 36: invertierender Eingang
- 38: Ausgang
- 40: invertierender Verstärker
- 42: zweiter Operationsverstärker
- 44: vierter Widerstand
- 46: fünfter Widerstand
- 48: sechster Widerstand
- 50: Analog-Digital-Umsetzer
- 52: Referenzquelle
- 54: siebter Widerstand
- 56: zweiter Schalter
- 58: Mikrocontroller
- 60: Konditionierungsschaltung
- 62: Shunt-Widerstand

## Patentansprüche

1. Schaltungsanordnung (10) zur Auswertung eines analogen elektrischen Signals, mit
einer Steuereinrichtung (58),
einer Eingangsschaltung (18) zum Anlegen eines Eingangssignals, einer mit der Eingangsschaltung (18) elektrisch verbundenen Konditionierungsschaltung (60) zur Umwandlung des Eingangssignals in ein Messsignal,
einen mit der Konditionierungsschaltung (60) elektrisch verbundenen Analog-Digital-Umsetzer (50) zur Umwandlung des Messsignals in einen digitalen Wert und
einer Referenzquelle (52), die ein bekanntes Referenzsignal ausgibt, wobei
eine erste Schaltvorrichtung (20) vorgesehen ist, die das Eingangssignal wahlweise von der Konditionierungsschaltung (60) trennt oder der Konditionierungsschaltung (60) zuführt, und
eine zweite Schaltvorrichtung (56) vorgesehen ist, die das Referenzsignal wahlweise der Eingangsschaltung (18) zuführt oder von der Eingangsschaltung (18) trennt,
wobei die Steuereinrichtung (58) ausgebildet ist, einen Verstärkungsfehler der Schaltungsanordnung (10) zu bestimmen, wenn das Eingangssignal von der Konditionierungsschaltung (60) getrennt ist und das Referenzsignal der Eingangsschaltung (18) zugeführt wird,
**dadurch gekennzeichnet, dass**
die Steuereinrichtung (58) ausgebildet ist, einen Offsetfehler der Schaltungsanordnung (10) zu bestimmen, wenn das Eingangssignal von der Konditionierungsschaltung (60) getrennt ist und das Referenzsignal nicht der Eingangsschaltung (18) zugeführt wird,
die Konditionierungsschaltung (60) ausgebildet ist, das Referenzsignal dem Messsignal hinzuzuaddieren, und
die Steuereinrichtung (58) ausgebildet ist, anhand des Offsetfehlers und/oder des Verstärkungsfehlers Bauteilfehler der Schaltungsanordnung (10) zu erkennen und bei Erkennen eines Bauteilfehlers ein Warnsignal auszugeben.

2. Schaltungsanordnung (10) nach Anspruch 1,
**dadurch gekennzeichnet, dass**
die Steuereinrichtung (58) mit dem Analog-Digital-Umsetzer (50) verbunden ist und den Verstärkungsfehler und/oder den Offsetfehler in dem digitalen Wert korrigiert.

3. Schaltungsanordnung (10) nach Anspruch 1 oder 2,
**dadurch gekennzeichnet, dass**
die Steuereinrichtung (58) ausgebildet ist, den Offsetfehler und/oder den Verstärkungsfehler wiederholt zu bestimmen.

4. Schaltungsanordnung (10) nach zumindest einem der vorstehenden Ansprüche,
**dadurch gekennzeichnet, dass**
die Steuereinrichtung (58) ausgebildet ist, den Offsetfehler und den Verstärkungsfehler nacheinander zu bestimmen und zwischen der Bestimmung des Offsetfehlers und des Verstärkungsfehlers das Eingangssignal auszuwerten.

5. Schaltungsanordnung (10) nach zumindest einem der vorstehenden Ansprüche,
**dadurch gekennzeichnet, dass**
die Eingangsschaltung (18) zwei Anschlussklemmen (12a, 12b) für das Eingangssignal und eine Schutzschaltung (16) umfasst, wobei eine der Anschlussklemmen (12b) vorzugsweise mit einem Massepotential (14) verbunden ist.

6. Schaltungsanordnung (10) nach zumindest einem der vorstehenden Ansprüche,
**dadurch gekennzeichnet, dass**
die Konditionierungsschaltung (60) einen Spannungsteiler (22, 24, 26) umfasst.

7. Schaltungsanordnung (10) nach zumindest einem der vorstehenden Ansprüche,
**dadurch gekennzeichnet, dass**
die Konditionierungsschaltung (60) einen Impedanzwandler, insbesondere einen Spannungsfolger (30), umfasst.

8. Schaltungsanordnung (10) nach zumindest einem der vorstehenden Ansprüche,
**dadurch gekennzeichnet, dass**
die Konditionierungsschaltung (60) einen Verstärker, insbesondere einen invertierenden Verstärker (40), umfasst.

9. Schaltungsanordnung (10) nach zumindest einem der vorstehenden Ansprüche,
**dadurch gekennzeichnet, dass**
die Referenzquelle (52) eine Spannungsquelle umfasst.

10. Schaltungsanordnung (10) nach zumindest einem der vorstehenden Ansprüche,
**dadurch gekennzeichnet, dass**
die Referenzquelle (52) eine Stromquelle umfasst.

11. Schaltungsanordnung (10) nach zumindest einem der vorstehenden Ansprüche,
**dadurch gekennzeichnet, dass**
die Größe des Referenzsignals veränderbar und/oder einstellbar ist.

12. Schaltungsanordnung (10) nach zumindest einem der vorstehenden Ansprüche,
**gekennzeichnet durch**
eine zweite Eingangsschaltung zum Anlegen des Eingangssignals,
eine mit der zweiten Eingangsschaltung elektrisch verbundene zweite Konditionierungsschaltung zur Veränderung des Eingangssignals in ein zweites Messsignal,
einen mit der zweiten Konditionierungsschaltung elektrisch verbundenen zweiten Analog-Digital-Umsetzer zur Umwandlung des zweiten Messsignals in einen zweiten digitalen Wert und
eine zweite Referenzquelle, die ein bekanntes zweites Referenzsignal ausgibt,
wobei
eine weitere erste Schaltvorrichtung vorgesehen ist, die das Eingangssignal wahlweise von der zweiten Konditionierungsschaltung trennt oder der zweiten Konditionierungsschaltung zuführt, und
eine weitere zweite Schaltvorrichtung vorgesehen ist, die das zweite Referenzsignal wahlweise der zweiten Eingangsschaltung zuführt oder von der zweiten Eingangsschaltung trennt, wobei
die Steuereinrichtung ausgebildet ist, einen zweiten Offsetfehler der Schaltungsanordnung (10) zu bestimmen, wenn das Eingangssignal von der zweiten Konditionierungsschaltung getrennt ist und das zweite Referenzsignal nicht der zweiten Eingangsschaltung zugeführt wird, und einen zweiten Verstärkungsfehler der Schaltungsanordnung (10) zu bestimmen, wenn das Eingangssignal von der zweiten Konditionierungsschaltung getrennt ist und das zweite Referenzsignal der zweiten Eingangsschaltung zugeführt wird.

13. Schaltungsanordnung (10) nach Anspruch 12,
**dadurch gekennzeichnet, dass**
die Steuereinrichtung (58) ausgebildet ist, den zweiten Offsetfehler und/oder den zweiten Verstärkungsfehler zu anderen Zeitpunkten zu bestimmen, als den Offsetfehler und/oder den Verstärkungsfehler.

14. Verfahren zur Auswertung eines analogen elektrischen Signals, bei welchem
ein Eingangssignal an einer Eingangsschaltung (18) angelegt wird, eine mit der Eingangsschaltung (18) elektrisch verbundene Konditionierungsschaltung (60) das Eingangssignal in ein Messsignal umwandelt, ein mit der Konditionierungsschaltung (60) elektrisch verbundener Analog-Digital-Umsetzer (50) das Messsignal in einen digitalen Wert umwandelt, und
eine Referenzquelle (52) ein bekanntes Referenzsignal ausgibt,
wobei
mittels einer ersten Schaltvorrichtung (20) das Eingangssignal wahlweise von der Konditionierungsschaltung (60) getrennt oder der Konditionierungsschaltung (60) zugeführt wird und
mittels einer zweiten Schaltvorrichtung (56) das Referenzsignal wahlweise der Eingangsschaltung (18) zugeführt oder von der Eingangsschaltung (18) getrennt wird,
wobei
ein Verstärkungsfehler bestimmt wird, wenn das Eingangssignal von der Konditionierungsschaltung (60) getrennt ist und das Referenzsignal der Eingangsschaltung (18) zugeführt wird,
**dadurch gekennzeichnet, dass**
ein Offsetfehler bestimmt wird, wenn das Eingangssignal von der Konditionierungsschaltung (60) getrennt ist und das Referenzsignal nicht der Eingangsschaltung (18) zugeführt wird,
die Konditionierungsschaltung (60) das Referenzsignal dem Messsignal hinzuaddiert und
die Steuereinrichtung (58) anhand des Offsetfehlers und/oder des Verstärkungsfehlers Bauteilfehler der Schaltungsanordnung (10) erkennt und bei Erkennen eines Bauteilfehlers ein Warnsignal ausgibt.

## Claims

1. A circuit arrangement (10) for evaluating an analog electrical signal comprising
a control device (58);
an input circuit (18) for applying an input signal;
a conditioning circuit (60) electrically connected to the input circuit (18) for converting the input signal into a measured signal;
an analog-to-digital converter (50) electrically connected to the conditioning circuit (60) for converting the measured signal into a digital value; and
a reference source (52) which outputs a known reference signal,
wherein
a first switching apparatus (20) is provided which selectively separates the input signal from the conditioning circuit (60) or supplies it to the conditioning circuit (60); and
a second switching apparatus (56) is provided which selectively supplies the reference signal to the input circuit (18) or separates it from the input circuit (18);
wherein the control device (58) is configured to determine a gain error of the circuit arrangement (10) when the input signal is separated from the conditioning circuit (60) and the reference signal is supplied to the input circuit (18),
**characterized in that**
the control device (58) is configured to determine an offset error of the circuit arrangement (10) when the input signal is separated from the conditioning circuit (60) and the reference signal is not supplied to the input circuit (18);
the conditioning circuit (60) is configured to add the reference signal to the measured signal; and
the control device (58) is configured to recognize component defects of the circuit arrangement (10) with reference to the offset error and/or to the gain error and to output a warning signal on recognition of a component defect.

2. A circuit arrangement (10) in accordance with claim 1,
**characterized in that**
the control device (58) is connected to the analog-to-digital converter (50) and corrects the gain error and/or the offset error in the digital value.

3. A circuit arrangement (10) in accordance with claim 1 or claim 2,
**characterized in that**
the control device (58) is configured to determine the offset error and/or the gain error repeatedly.

4. A circuit arrangement (10) in accordance with at least one of the preceding claims,
**characterized in that**
the control device (58) is configured to determine the offset error and the gain error after one another and to evaluate the input signal between the determination of the offset error and of the gain error.

5. A circuit arrangement (10) in accordance with at least one of the preceding claims,
**characterized in that**
the input circuit (18) comprises two connector terminals (12a, 12b) for the input signal and a protective circuit (16), with one of the connector terminals (12b) preferably being connected to a ground potential (14).

6. A circuit arrangement (10) in accordance with at least one of the preceding claims,
**characterized in that**
the conditioning circuit (60) comprises a voltage divider (22, 24, 26).

7. A circuit arrangement (10) in accordance with at least one of the preceding claims,
**characterized in that**
the conditioning circuit (60) comprises an impedance converter, in particular a voltage follower (30).

8. A circuit arrangement (10) in accordance with at least one of the preceding claims,
**characterized in that**
the conditioning circuit (60) comprises an amplifier, in particular an inverting amplifier (40).

9. A circuit arrangement (10) in accordance with at least one of the preceding claims,
**characterized in that**
the reference source (52) comprises a voltage source.

10. A circuit arrangement (10) in accordance with at least one of the preceding claims,
**characterized in that**
the reference source (52) comprises a current source.

11. A circuit arrangement (10) in accordance with at least one of the preceding claims,
**characterized in that**
the magnitude of the reference signal is changeable and/or settable.

12. A circuit arrangement (10) in accordance with at least one of the preceding claims,
**characterized by**
a second input circuit for applying the input signal;
a second conditioning circuit electrically connected to the second input circuit for changing the input signal into a second measured signal;
a second analog-to-digital converter electrically connected to the second conditioning circuit for converting the second measured signal into a second digital value; and
a second reference source which outputs a known second reference signal,
wherein
a further first switching apparatus is provided which selectively separates the input signal from the second conditioning circuit or supplies it to the second conditioning circuit; and
a further second switching apparatus is provided which selectively supplies the second reference signal to the second input circuit or separates it from the second input circuit; wherein
the control device is configured to determine a second offset error of the circuit arrangement (10) when the input signal is separated from the second conditioning circuit and the second reference signal is not supplied to the second input circuit; and to determine a second gain error of the circuit arrangement (10) when the input signal is separated from the second conditioning circuit and the second reference signal is supplied to the second input circuit.

13. A circuit arrangement (10) in accordance with claim 12,
**characterized in that**
the control device (58) is configured to determine the second offset error and/or the second gain error at different points in time than the offset error and/or the gain error.

14. A method of evaluating an analog electrical signal, in which an input signal is applied to an input circuit (18);
a conditioning circuit (60) electrically connected to the input circuit (18) converts the input signal into a measured signal;
an analog-to-digital converter (50) electrically connected to the conditioning circuit (60) converts the measured signal into a digital value; and
a reference source (52) outputs a known reference signal,
wherein
the input signal is selectively separated from the conditioning circuit (60) by means of a first switching apparatus (20) or is supplied to the conditioning circuit (60); and
the reference signal is selectively supplied to the input circuit (18) by means of a second switching apparatus (56) or is separated from the input circuit (18);
wherein
a gain error is determined when the input signal is separated from the conditioning circuit (60) and the reference signal is supplied to the input circuit (18),
**characterized in that**
an offset error is determined when the input signal is separated from the conditioning circuit (60) and the reference signal is not supplied to the input circuit (18);
**in that** the conditioning circuit (60) adds the reference signal to the measured signal; and
**in that** the control device (58) recognizes component defects of the circuit arrangement (10) with reference to the offset error and/or to the gain error and outputs a warning signal on recognition of a component defect.

## Revendications

1. Circuit (10) destiné à évaluer un signal électrique analogique, comprenant :
un moyen de commande (58),
un circuit d'entrée (18) destiné à appliquer un signal d'entrée,
un circuit de conditionnement (60) relié électriquement au circuit d'entrée (18) et destiné à transformer le signal d'entrée en un signal de mesure,
un convertisseur analogique-numérique (50) relié électriquement au circuit de conditionnement (60) et destiné à transformer le signal de mesure en une valeur numérique et
une source de référence (52), qui émet un signal de référence connu,
dans lequel
un premier dispositif de commutation (20) est prévu, qui sélectivement sépare le signal d'entrée du circuit de conditionnement (60) ou l'alimente dans le circuit de conditionnement (60), et
un second dispositif de commutation (56) est prévu, qui sélectivement alimente le signal de référence dans le circuit d'entrée (18) ou le sépare du circuit d'entrée (18),
dans lequel le moyen de commande (58) est conçu pour déterminer une erreur d'amplification du circuit (10), quand le signal d'entrée est séparé du circuit de conditionnement (60) et que le signal de référence est alimenté dans le circuit d'entrée (18),
**caractérisé en ce que**
le moyen de commande (58) est conçu pour déterminer une erreur de décalage du circuit (10), quand le signal d'entrée est séparé du circuit de conditionnement (60) et que le signal de référence n'est pas alimenté dans le circuit d'entrée (18),
le circuit de conditionnement (60) est conçu pour ajouter le signal de référence au signal de mesure, et
le moyen de commande (58) est conçu pour, à l'aide de l'erreur de décalage et/ou de l'erreur d'amplification, détecter des défauts de composant du circuit (10) et émettre un signal d'avertissement en cas de détection d'un défaut de composant.

2. Circuit (10) selon la revendication 1,
**caractérisé en ce que**
le moyen de commande (58) est relié au convertisseur analogique-numérique (50) et corrige l'erreur d'amplification et/ou l'erreur de décalage dans la valeur numérique.

3. Circuit (10) selon la revendication 1 ou 2,
**caractérisé en ce que**
le moyen de commande (58) est conçu pour déterminer l'erreur de décalage et/ou l'erreur d'amplification à plusieurs reprises.

4. Circuit (10) selon au moins une des revendications précédentes,
**caractérisé en ce que**
le moyen de commande (58) est conçu pour déterminer l'erreur de décalage et l'erreur d'amplification l'une après l'autre et évaluer le signal d'entrée entre la détermination de l'erreur de décalage et de l'erreur d'amplification.

5. Circuit (10) selon au moins une des revendications précédentes,
**caractérisé en ce que**
le circuit d'entrée (18) comprend deux bornes de raccordement (12a, 12b) pour le signal d'entrée et un circuit de protection (16), l'une des bornes de raccordement (12b) étant de préférence reliée à un potentiel de terre (14).

6. Circuit (10) selon au moins une des revendications précédentes,
**caractérisé en ce que**
le circuit de conditionnement (60) comprend un diviseur de tension (22, 24, 26).

7. Circuit (10) selon au moins une des revendications précédentes,
**caractérisé en ce que**
le circuit de conditionnement (60) comprend un convertisseur d'impédance, en particulier un suiveur de tension (30).

8. Circuit (10) selon au moins une des revendications précédentes,
**caractérisé en ce que**
le circuit de conditionnement (60) comprend un amplificateur, en particulier un amplificateur inverseur (40).

9. Circuit (10) selon au moins une des revendications précédentes,
**caractérisé en ce que**
la source de référence (52) comprend une source de tension.

10. Circuit (10) selon au moins une des revendications précédentes,
**caractérisé en ce que**
la source de référence (52) comprend une source de courant.

11. Circuit (10) selon au moins une des revendications précédentes,
**caractérisé en ce que**
la grandeur du signal de référence peut être modifiée et/ou réglée.

12. Circuit (10) selon au moins une des revendications précédentes,
**caractérisé par**
un second circuit d'entrée destiné à appliquer le signal d'entrée,
un second circuit de conditionnement relié électriquement au second circuit d'entrée et destiné à changer le signal d'entrée en un second signal de mesure,
un second convertisseur analogique-numérique relié électriquement au second circuit de conditionnement et destiné à transformer le second signal de mesure en une seconde valeur numérique et
une seconde source de référence, qui émet un second signal de référence connu,
dans lequel
un autre premier dispositif de commutation est prévu, qui sélectivement sépare le signal d'entrée du second circuit de conditionnement ou l'alimente dans le second circuit de conditionnement, et
un autre second dispositif de commutation est prévu, qui sélectivement alimente le second signal de référence dans le second circuit d'entrée ou le sépare du second circuit d'entrée, dans lequel
le moyen de commande est conçu pour déterminer une seconde erreur de décalage du circuit (10), quand le signal d'entrée est séparé du second circuit de conditionnement et que le second signal de référence n'est pas alimenté dans le second circuit d'entrée, et déterminer une seconde erreur d'amplification du circuit (10), quand le signal d'entrée est séparé du second circuit de conditionnement et que le second signal de référence est alimenté dans le second circuit d'entrée.

13. Circuit (10) selon la revendication 12,
**caractérisé en ce que**
le moyen de commande (58) est conçu pour déterminer la seconde erreur de décalage et/ou la seconde erreur d'amplification à d'autres moments que l'erreur de décalage et/ou l'erreur d'amplification.

14. Procédé d'évaluation d'un signal électrique analogique, dans lequel un signal d'entrée est appliqué à un circuit d'entrée (18),
un circuit de conditionnement (60) relié électriquement au circuit d'entrée (18) transforme le signal d'entrée en un signal de mesure,
un convertisseur analogique-numérique (50) relié électriquement au circuit de conditionnement (60) transforme le signal de mesure en une valeur numérique, et
une source de référence (52) émet un signal de référence connu, dans lequel
le signal d'entrée est sélectivement séparé du circuit de conditionnement (60) ou alimenté dans le circuit de conditionnement (60) au moyen d'un premier dispositif de commutation (20) et
le signal de référence est sélectivement alimenté dans le circuit d'entrée (18) ou séparé du circuit d'entrée (18) au moyen d'un second dispositif de commutation (56),
dans lequel
une erreur d'amplification est déterminée quand le signal d'entrée est séparé du circuit de conditionnement (60) et que le signal de référence est alimenté dans le circuit d'entrée (18),
**caractérisé en ce que**
une erreur de décalage est déterminée quand le signal d'entrée est séparé du circuit de conditionnement (60) et que le signal de référence n'est pas alimenté dans le circuit d'entrée (18),
le circuit de conditionnement (60) ajoute le signal de référence au signal de mesure, et
le moyen de commande (58) détecte, à l'aide de l'erreur de décalage et/ou de l'erreur d'amplification, des défauts de composant du circuit (10) et émet un signal d'avertissement en cas de détection d'un défaut de composant.
